# FASCICULE DE BREVET EUROPEEN

(11) **EP 1 440 462 B1**
(45) Date de publication et mention de la délivrance du brevet: **31.10.2012**
(21) Numéro de dépôt: 02800174.1
(22) Date de dépôt: 02.10.2002
(51) Int. Cl.: H01L 21/304, B23C 3/13, G05B 19/19, H01L 21/66

(54) **PROCÉDÉ D'AMINCISSEMENT D'UNE PUCE DE CIRCUIT INTÉGRÉ**
VERFAHREN ZUM DÜNNEN EINES CHIPS MIT INTEGRIERTER SCHALTUNG
METHOD FOR THINNING AN INTEGRATED CIRCUIT DIE

(30) Priorité: 04.10.2001 FR 0112792
(43) Date de publication de la demande: 28.07.2004
(73) Titulaire: CENTRE NATIONAL D'ETUDES SPATIALES, 75001 Paris (FR)
(72) Inventeur: DESPLATS, Romain, F-31400 Toulouse (FR); BEAUDOIN, Félix, F-31450 BAZIEGE (FR)
(74) Mandataire: Blot, Philippe Robert Emile
(86) Numéro de dépôt international: PCT/FR2002/003358
(87) Numéro de publication internationale: WO 2003/030231

(56) Documents cités:
- EP-A- 0 514 046
- US-A- 5 698 474
- US-B1- 6 245 587
- BEAUDOIN F ET AL: "SILICON THINNING AND POLISHING ON PACKAGED DEVICES" MICROELECTRONICS AND RELIABILITY, ELSEVIER SCIENCE LTD, GB, vol. 41, no. 9/10, 1 octobre 2001 (2001-10-01), pages 1557-1561, XP001058247 ISSN: 0026-2714
- PATENT ABSTRACTS OF JAPAN vol. 018, no. 203 (M-1590), 11 avril 1994 (1994-04-11) -& JP 06 008028 A (EISUKE YOKOYAMA), 18 janvier 1994 (1994-01-18)
- PATENT ABSTRACTS OF JAPAN vol. 016, no. 438 (M-1309), 11 septembre 1992 (1992-09-11) & JP 04 152014 A (MITSUBISHI HEAVY IND LTD), 26 mai 1992 (1992-05-26)

## Description

La présente invention concerne un procédé d'amincissement d'une plaquette de circuit intégré formé dans un matériau semi-conducteur, présentant une surface bombée initiale, dans lequel la surface bombée initiale de la plaquette est usinée par un outil d'usinage pour mettre à nu une surface finale sous-jacente.

Les circuits intégrés actuels sont d'une complexité croissante. Il est ainsi difficile d'observer et d'étudier le coeur du circuit au travers des nombreuses couches de métal couvrant la surface. De plus en plus de techniques d'étude et d'analyse d'un circuit intégré sont mises en oeuvre depuis la face arrière de ce dernier. Pour accéder à cette face, et permettre l'analyse et l'observation, il convient d'abord d'ouvrir le boîtier plastique dans lequel est disposée la plaquette de matériau semi-conducteur contenant le circuit intégré. Le bloc de matériau semi-conducteur doit ensuite être aminci de manière à ne laisser subsister au dessus du circuit proprement dit qu'une épaisseur très fine de matériau semi-conducteur afin de permettre la mise en oeuvre des méthodes d'analyse et d'observation.

L'analyse du circuit s'effectue par exemple par microscopie à émission de lumière en détectant les zones chaudes par détection infrarouge à travers la couche de silicium amincie.

Pour permettre une observation satisfaisante, il convient que la couche résiduelle de matériau semi-conducteur recouvrant le circuit proprement dit soit inférieure à 50 microns.

L'ablation du matériau semi-conducteur est réalisée par une fraise rotative mise en oeuvre, par exemple, dans une installation connue sous le nom de "chipunzip" et commercialisée par la société "Hypervision". Cette ablation est réalisée par déplacement de la fraise dans un plan, ce qui permet, après passage de la fraise, d'obtenir une surface généralement plane à la surface de la plaquette de matériau semi-conducteur.

A l'issue de la phase d'amincissement, on constate que certaines régions du circuit intégré sont recouvertes d'une épaisseur très réduite de matériau semi-conducteur alors que d'autres régions du circuit intégré sont recouvertes d'une épaisseur très importante de matériau semi-conducteur. L'observation de l'échantillon est ainsi rendue difficile du fait des différences d'épaisseur du matériau semi-conducteur encore présent au-dessus du circuit proprement dit. L'épaisseur n'étant pas constante, les propriétés optiques du matériel sont altérées rendant l'analyse problèmatique.

L'invention a pour but de proposer un procédé et une installation pour l'amincissement d'une plaquette de circuit intégré permettant d'améliorer l'observation ou l'analyse ultérieure du circuit intégré.

A cet effet, l'invention a pour objet un procédé d'amincissement d'une plaquette de circuit intégré formée dans un matériau semi-conducteur, selon la revendication 1.

Suivant des modes particuliers de mise en oeuvre, le procédé comporte l'une ou plusieurs des caractéristiques suivantes :
- ladite étape de définition d'un chemin d'usinage comporte une étape de définition de la surface finale escomptée et une étape d'élaboration du chemin d'usinage à partir de la surface finale escomptée et des caractéristiques dimensionnelles de l'outil d'usinage ;
- ledit outil d'usinage est une fraise généralement sphérique présentant axialement un méplat d'extrémité ;
- le diamètre de la fraise est compris entre 2 mm et 4 mm ;
- vitesse de rotation de la fraise est comprise entre 25000 tr/min et 75000 tr/min ;
- l'épaisseur moyenne d'ablation du matériau semi-conducteur est comprise entre 10 µm et 40 µm à chaque passe ;
- la vitesse d'avancement de la fraise est comprise entre 6,3 mm/min et 12,5 mm/min ;
- ladite étape de modélisation comporte une étape de recueil de la position et de l'altitude d'un nombre prédéterminé de points sur ladite surface bombée initiale et une modélisation de la surface initiale bombée à partir de fonctions SPLINE ; et
- ladite étape d'analyse de ladite surface bombée initiale comporte une étape de mesure de l'altitude d'un nombre défini de points à l'aide d'un microscope confocal 3D ou d'un profilomètre optique 3D et ladite étape de modélisation comporte une étape de création d'un modèle de la surface à partir des altitudes mesurées.

L'invention sera mieux comprise à la lecture de la description qui va suivre, donnée uniquement à titre d'exemple et faite en se référant aux dessins sur lesquels :
- la figure 1 est une vue schématique d'un composant électronique renfermant une plaquette de circuit intégré formée dans un matériau semi-conducteur;
- la figure 2 est une vue en perspective d'une installation d'amincissement d'une plaquette de circuit intégré ;
- la figure 3 est un organigramme illustrant les différentes étapes d'amincissement selon l'invention ;
- la figure 4 est une vue en perspective d'un composant électronique dont la surface arrière de la plaquette de matériau semi-conducteur a été mise à nu ;
- la figure 5 est une vue en perspective avec arrachement du composant électronique illustrant une phase de mesure de la surface bombée initiale de la plaquette de matériau semi-conducteur ;
- la figure 6 est une illustration dans un repère orthonormé de la modélisation de la surface bombée initiale de la plaquette de matériau semi-conducteur ;
- la figure 7 est une vue en élévation d'une fraise pour l'usinage d'une plaquette de matériau semi-conducteur ;
- la figure 8 est une vue identique à celle de la figure 6 sur laquelle figure un chemin d'usinage non revendiqué suivi par l'outil d'usinage de la surface bombée ;
- la figure 9 est une vue schématique de côté illustrant la position de la surface usinée et le chemin d'usinage suivi par l'outil ;
- la figure 10 est une vue identique à celle de la figure 5 montrant le travail de l'outil ;
- la figure 11 est une vue schématique illustrant une variante de chemin d'usinage non revendiquée; et
- la figure 12 est une vue en perspective d'une plaquette de circuit intégré illustrant la variante revendiquée d'un chemin d'usinage.

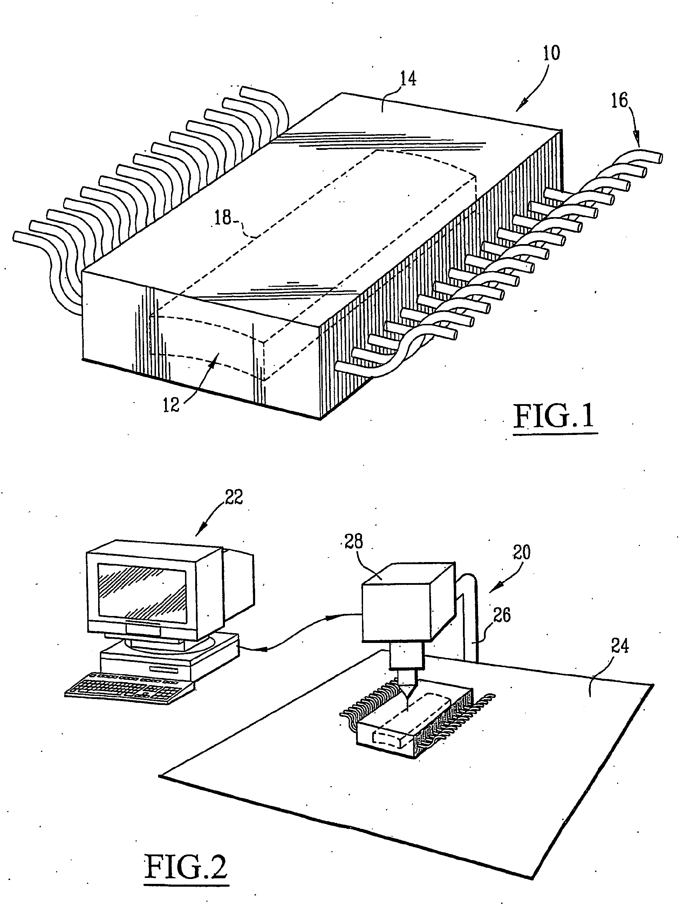

Sur la figure 1, est représenté un composant électronique 10 comportant un circuit intégré formé dans une plaquette 12 d'un matériau semi-conducteur tel que du silicium. La plaquette 12 est noyée dans un boîtier 14 en matière plastique. Des pattes de connexion 16 émergent du boîtier 14 et sont adaptées pour assurer la connexion électrique du circuit intégré. La plaquette 12 comportant le circuit intégré présente une surface arrière 18 qui est bombée vers l'extérieur. Ainsi, cette surface est généralement convexe, le sommet de la surface étant généralement situé dans la partie médiane de la surface 18.

Les inventeurs ont constaté que les plaquettes de matériau semi-conducteur, noyées dans un boîtier en matière plastique, subissent, lors de la formation du boîtier, une déformation conduisant à ce que la face arrière de la plaquette de matériau semi-conducteur soit bombée. Cette déformation permanente du bloc de matériau semi-conducteur est due aux contraintes exercées par le boîtier. On constate que l'écart de niveau entre les parties les plus élevées de la surface bombée et les parties les plus basses peut dépasser 50 microns.

Sur la figure 2 est représentée une installation d'amincissement de la plaquette 12 de circuit intégré. Cette installation comporte une unité 20 d'usinage et de contrôle reliée à une unité de pilotage 22.

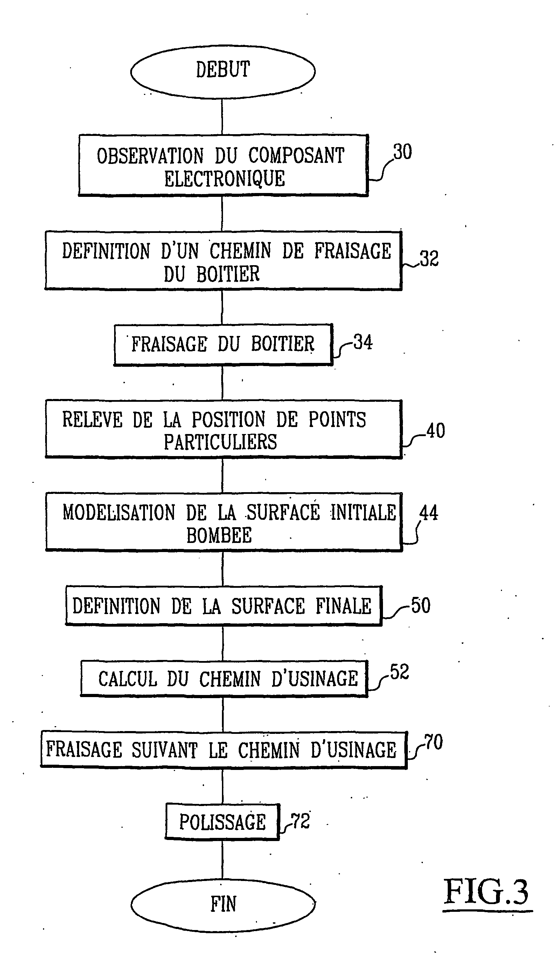

Cette unité d'usinage et de contrôle 20 est constituée par exemple par le produit commercialisé par la société HYPERVISION sous la dénomination "chipunzip". L'unité de pilotage 22 met en oeuvre par exemple le logiciel de commande "Smart CAM Production Milling" de la société SDRC et-est adaptée en outre pour la mise en oeuvre du procédé décrit dans la suite en regard de la figure 3.

L'unité 20 d'usinage et de contrôle comporte une platine 24 de support du composant électronique 10 et une potence 26 à l'extrémité de laquelle est supportée une tête 28 porte-outil. Cette tête est adaptée pour le support et l'entraînement d'un outil d'usinage tel qu'une fraise. Elle permet le déplacement de cette fraise suivant les trois directions de l'espace sous la commande de l'unité de pilotage 22. La tête 28 permet en outre le support et le déplacement d'une sonde de mesure propre notamment à relever par contact l'altitude de différents points à la surface d'un échantillon placé sur la platine 24. La tête 28 permet également le support d'un équipement d'observation tel qu'une caméra.

Le procédé mis en oeuvre sous la commande de l'unité de pilotage 22 va maintenant être décrit en référence à la figure 3 et aux figures suivantes illustrant les différentes étapes mises en oeuvre.

Le procédé a pour objectif de mettre à nu la surface arrière 18 du circuit intégré, et d'amincir la plaquette de circuit intégré, afin de réduire la quantité de matériau semi-conducteur résiduel présent à l'arrière du circuit intégré proprement dit.

Initialement, le composant électronique 10 à étudier est placé sur la platine 24 de l'unité d'usinage et de contrôle avec sa face arrière tournée vers la tête 28.

Initialement, une observation du composant électronique 10 est effectuée à l'étape 30. A partir de cette observation, un chemin de fraisage du boîtier 14 est défini à l'étape 32. Ce fraisage du boîtier est effectué à l'étape 34, afin de mettre à nu la surface bombée initiale 18 de la plaquette de circuit intégré. Les étapes 30 à 34 sont conduites par tout procédé connu approprié.

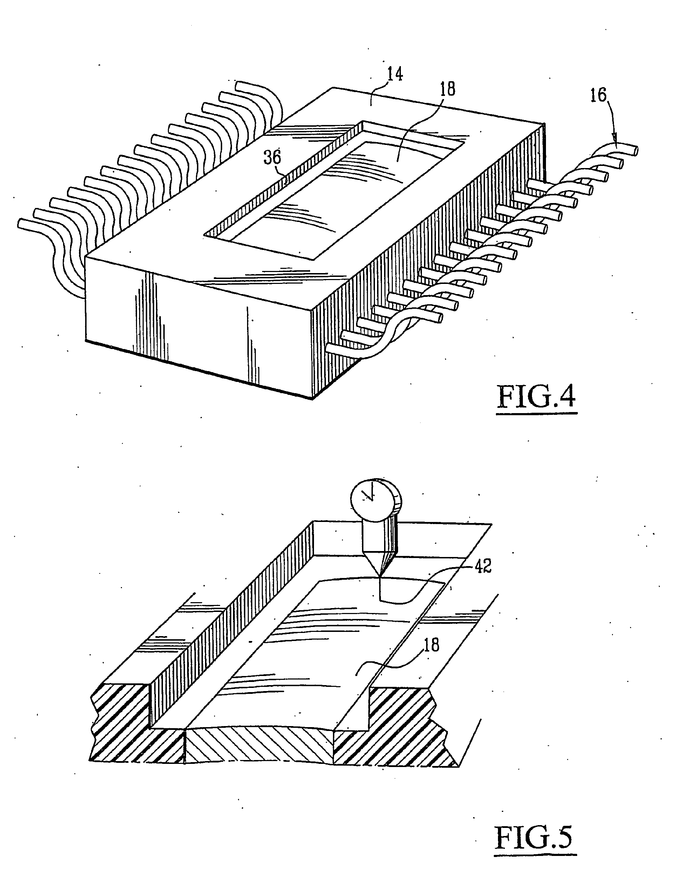

A l'issue de ces étapes, le composant électronique 10 est dans la configuration illustrée sur la figure 4, où la surface bombée initiale 18 est visible et accessible au travers d'une fenêtre 36 ménagée dans le boîtier 14.

A l'étape suivante 40, illustrée sur la figure 5, un relevé de l'altitude et des positions d'un ensemble de points particuliers de la surface initiale bombée 18 est effectué. Ce relevé est effectué par exemple par une sonde 42 amenée en contact successivement avec les différents points prédéterminés de la surface 18.

Le nombre de relevés est par exemple de neuf. Huit relevés sont effectués en des points disposés à la périphérie de la surface 18 et un dernier est effectué en un point disposé dans la partie médiane de la surface 18 au voisinage du sommet de la surface. Pour des surfaces complexes, le nombre de points où des relevés sont effectués peut être supérieur.

A partir des altitudes des points par rapport au plan de la platine et des positions dans le plan de la platine de ces mêmes points, une modélisation de la surface bombée 18 est réalisée à l'étape 44.

Cette modélisation est par exemple obtenue à partir de fonctions SPLINE établies par exemple par utilisation du logiciel Mathématica. Chaque courbe est définie de sorte qu'elle passe par trois points dont les positions et les altitudes ont été relevées.

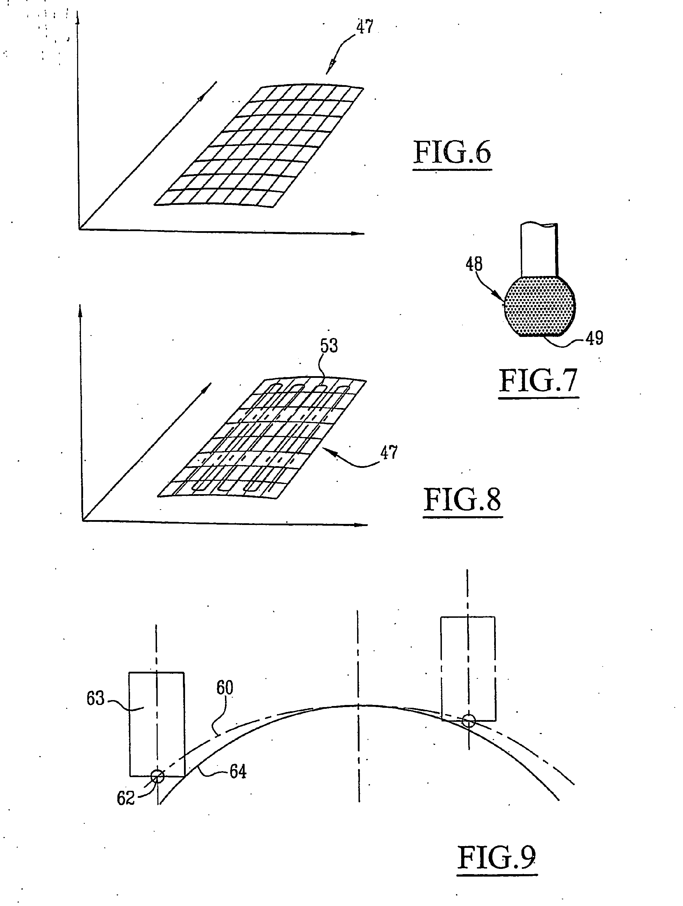

Dans la mesure où la surface bombée initiale 18 est essentiellement rectangulaire, quatre courbes sont d'abord définies par des fonctions SPLINE pour caractériser chaque côté du circuit. Deux nouvelles fonctions sont définies pour caractériser des courbes perpendiculaires passant par le point de mesure situé au voisinage du sommet de la surface. La modélisation proprement dite est ensuite déduite des fonctions précédemment définies. La surface modélisée notée 47 est illustrée sur la figure 6.

A partir de cette modélisation, une gamme d'usinage par fraisage de la surface 18 est définie. Cette gamme d'usinage est définie de telle sorte que la surface finale usinée présente globalement sensiblement le même profil que la surface bombée initiale 18, les surfaces finale et initiale s'étendant généralement parallèlement et étant séparées en tout point d'un intervalle sensiblement identique.

Avantageusement, la fraise utilisée lors du fraisage est entraînée en rotation autour d'un axe vertical s'étendant perpendiculairement à la surface de la platine 24, c'est-à-dire sensiblement perpendiculairement à la surface bombée initiale.

La vitesse de rotation de la fraise pour l'ablation du silicium est comprise entre 25000 et 75000 tr/min. La vitesse de déplacement de la fraise est comprise entre 6,3 et 12,5 mm/min et l'épaisseur de matériau éliminé à chaque passe est comprise entre 10 µm et 40 µm.

La dernière passe effectuée n'assure avantageusement qu'une ablation de 1 à 5 µm du matériau.

De préférence, la tête de la fraise 48 est de forme généralement sphérique, comme illustré sur la figure 7. Elle présente avantageusement un méplat 49 à son extrémité axiale.

Pour la définition de la gamme d'usinage, l'unité de pilotage 22 définit d'abord, à l'étape 50, la surface finale escomptée. Cette surface finale est obtenue par exemple par translation de la surface initiale modélisée d'une hauteur correspondant à l'épaisseur de matériau semi-conducteur à retirer.

A l'étape 52, le nombre de passes nécessaires et le chemin d'usinage de chaque passe sont définis afin d'obtenir la surface finale.

Les chemins d'usinage utilisés pour les différentes passes successives sont de préférence identiques.

Le chemin d'usinage de chaque passe prévoit, dans un exemple non revendiqué, le déplacement de la fraise suivant un chemin en boustrophédon, c'est-à-dire constitué d'une succession de segments parallèles les uns aux autres parcourus alternativement dans un sens et dans l'autre. Un tel chemin noté 53 est illustré sur la figure 8.

Le chemin d'usinage est défini en trois dimensions et, lors du déplacement général de la fraise suivant le parcours en boustrophédon, l'altitude de la base de la fraise varie pour suivre un profil décalé de la surface bombée initiale 18.

Comme illustré sur la figure 9, le chemin d'usinage suivi par la fraise notée 63 et schématisée sur la figure est défini en tenant compte des caractéristiques dimensionnelles de l'outil.

En particulier, le chemin 60 défini pour le point extrême 62 de la fraise 63 situé suivant son axe de rotation est décalé par rapport au profil de la surface escomptée 64, pour tenir compte de la forme et des dimensions de la fraise.

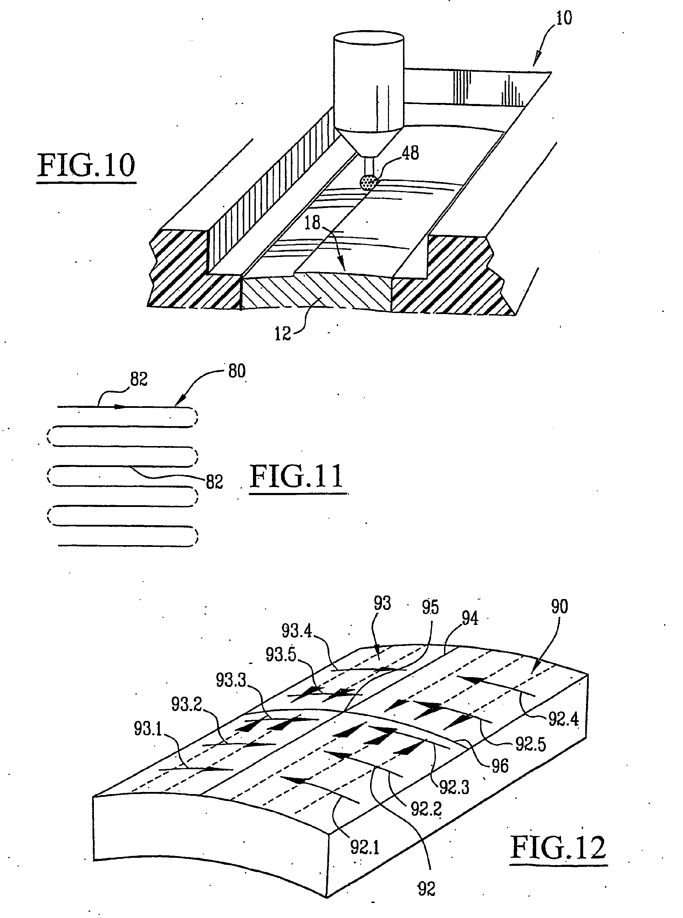

Comme illustré sur la figure 10, à l'étape 70, la fraise 48 est alors déplacée suivant la surface bombée de la plaquette de circuit intégré, afin d'amincir celui-ci.

Au cours du déplacement de la fraise, l'altitude de celle-ci est modifiée pour suivre le profil décalé de la surface bombée initiale 18. L'action de la fraise supprime tout au long du chemin d'usinage une même épaisseur de matériau semi-conducteur.

A l'issue du fraisage, une surface finale usinée est obtenue. Cette surface est polie, à l'étape 72, par mise en oeuvre de tout procédé adapté, afin de permettre l'observation du circuit en fonctionnement par un matériel adapté tel qu'un microscope à émission de lumière. Le polissage est effectué par exemple à l'aide successivement d'une patte de diamant polycristalline de 1 µm et 0,1 µm avec une tête rotative en coton parcourant la surface finale en suivant exactement les variations d'altitude du profil final modélisé.

On comprend qu'avec un procédé tel que décrit précédemment, la surface finale présente une courbure identique à celle de la surface bombée initiale 18. Dans la mesure où, lors de son encapsulage dans le boîtier, la plaquette de circuit intégré a été déformée uniformément, le circuit gravé dans le matériau semi-conducteur présente une courbure sensiblement identique à celle de la surface bombée initiale, mais également de la surface finale usinée. Ainsi, lors de l'observation, l'épaisseur de matériau semi-conducteur résiduel est constante sur toute l'étendue du circuit intégré, facilitant son observation.

Sur les figures 11 et 12 sont illustrées des variantes de réalisation du chemin d'usinage.

Le chemin d'usinage noté 80, non revendiqué et illustré sur la figure 11, est constitué d'une succession de segments parallèles parcourus alternativement dans un sens et dans l'autre, ces segments étant disjoints. Ainsi, le fraisage de la surface bombée initiale n'est assuré que sur les segments rectilignes 82 proprement dits et la fraise est écartée de la surface à usiner pour passer d'une extrémité d'un segment d'usinage 82 au segment d'usinage suivant. Le déplacement de la fraise à l'écart de la surface à usiner est illustré par des pointillés.

Avantageusement, l'usinage est effectué lors des premières passes suivant des trajets d'usinage tels qu'illustrés sur les figures 8 et 11. Les épaisseurs de matériau retirées à chaque passe sont comprises entre 10 µm et 40 µm et sont de préférence égales à 20 µm.

Les dernières passes sont destinées à retirer une épaisseur réduite de matériau. Celle-ci est par exemple comprise entre 1 et 5 µm.

Les configurations des deux dernières passes sont illustrées sur la figure 12, le chemin d'usinage noté 90 de la première des deux passes représenté en trait fort comporte une succession de segments d'usinage disjoints 92, 93. Ces segments sont parcourus d'un point bas de la surface à usiner vers un point haut de cette surface. Ces segments sont répartis de part et d'autre d'une ligne médiane 94 passant par le sommet 95 de la surface. Ainsi, deux ensembles de segments d'usinage sont définis de part et d'autre de la ligne médiane 94, chaque segment s'étendant perpendiculairement à la ligne médiane 94. Les segments d'usinage répartis de part et d'autre de la crête s'étendent parallèlement les uns aux autres.

En outre, les segments disjoints 92, 93 sont répartis de part et d'autre d'une seconde ligne médiane 96 passant par le sommet 95 et s'étendant perpendiculairement à la première ligne médiane 94.

Les segments contenus dans chacun des quartiers définis par les lignes médianes 94, 96 sont parcourus par la fraise successivement en se rapprochant progressivement du sommet. Ainsi, les segments 92 sont parcourus dans l'ordre 92.1, 92.2, 92.3 en se rapprochant progressivement de la seconde ligne médiane 96, alors que les segments 92 disposés de l'autre côté de la ligne médiane 96 sont parcourus dans l'ordre 92.4, 92.5 en se rapprochant progressivement de la seconde ligne médiane 96.

De manière analogue, les segments 93 sont parcourus successivement de chaque côté de la seconde ligne médiane 96 suivant l'ordre 93.1, 93.2, 93.3 puis 93.4 et enfin 93.5.

A l'issue de cette passe couvrant toute la surface de la plaquette, une seconde passe est réalisée suivant une configuration analogue du chemin d'usinage, 92, 93, cette configuration étant toutefois décalée de 90° par rapport à celle du chemin d'usinage précédent.

Lors de cette seconde passe, chaque segment d'usinage représenté en pointillé sur la figure 12 est parcouru depuis un point bas jusque la seconde ligne médiane 96, les segments d'usinage répartis de part et d'autre de la première ligne médiane 92 étant parcourus successivement en se rapprochant de cette première ligne d'usinage 94.

On constate qu'avec des passes réalisées suivant de tels chemins d'usinage, l'état de surface de la surface finale est particulièrement adaptée à l'observation.

Le procédé décrit tel que précédemment utilise, pour la modélisation de la surface bombée initiale 18, un relevé mécanique de l'altitude d'un certain nombre de points et une extrapolation de la définition de la surface à partir de ces points.

En variante, l'étape de modélisation comporte une étape initiale dans laquelle la surface bombée initiale 18 est observée à l'aide d'un microscope confocal 3D ou un profilomètre optique 3D pour mesurer l'altitude de la surface en un grand nombre de points. La modélisation de la surface est effectuée à partir des altitudes mesurées.

## Revendications

1. Procédé d'amincissement d'une plaquette (12) de circuit intégré formée dans un matériau semi-conducteur, présentant une surface bombée initiale (18), dans lequel la surface bombée initiale (18) de la plaquette est usinée par un outil d'usinage (48) pour mettre à nu une surface finale sous-jacente, **caractérisé en ce qu'**il comporte :
- une étape d'analyse de ladite surface bombée initiale (18),
- une étape de modélisation de ladite surface bombée initiale (18),
- une étape de pilotage de l'usinage en fonction de ladite modélisation, ledit usinage étant conduit pour que ladite surface finale présente globalement sensiblement le même profil que ladite surface bombée initiale (18), les surfaces finale et initiale s'étendant globalement généralement parallèlement et étant séparées en tout point d'un intervalle sensiblement identique,
- une étape (50, 52) de définition d'un chemin d'usinage (90) suivant lequel ledit outil d'usinage est déplacé, lequel chemin d'usinage (90) s'étend suivant les trois directions de l'espace et comporte, pour au moins une passe, un ensemble de segments disjoints (92) parcourus successivement suivant lesquels l'outil d'usinage (48) se déplace suivant un sens généralement ascendant par rapport à ladite surface initiale bombée (18), cette étape (50, 52) de définition du chemin d'usinage comportant :
• la délimitation de la surface à usiner, en quartiers définis par des première (94) et seconde (96) lignes médianes passant par le sommet (95) de la surface et perpendiculaires l'une par rapport à l'autre,
• la définition d'une première passe, dans laquelle l'outil d'usinage parcourt des segments d'usinage disjoints (92, 93), depuis un point bas de la surface à usiner vers un point haut de cette surface, ces segments d'usinage (92, 93) étant répartis de part et d'autre de la première ligne médiane (94) et de part et d'autre de la seconde ligne médiane (96), et dans laquelle les segments contenus dans chacun des quartiers sont parcourus par l'outil d'usinage successivement en se rapprochant progressivement du sommet, et
• la définition d'une seconde passe, faisant suite à la première passe, suivant une configuration analogue à celle de la première passe, cette configuration étant toutefois décalée de 90° par rapport à celle du chemin d'usinage de la première passe.

2. Procédé selon la revendication 1, **caractérisé en ce que** ladite étape de définition d'un chemin d'usinage (53) comporte une étape (50) de définition de la surface finale escomptée et une étape (52) d'élaboration du chemin d'usinage (52) à partir de la surface finale escomptée et des caractéristiques dimensionnelles de l'outil d'usinage (48).

3. Procédé selon l'une quelconque des revendications précédentes, **caractérisé en ce que** ledit outil d'usinage est une fraise (48) généralement sphérique présentant axialement un méplat d'extrémité (49).

4. Procédé selon la revendication 3, **caractérisé en ce que** le diamètre de la fraise est compris entre 2 mm et 4 mm.

5. Procédé selon la revendication 3 ou 4, **caractérisé en ce que** la vitesse de rotation de la fraise est comprise entre 25000 tr/min et 75000 tr/min.

6. Procédé selon l'une quelconque des revendications 3 à 5, **caractérisé en ce que** l'épaisseur moyenne d'ablation du matériau semi-conduc-teur est comprise entre 10 µm et 40 µm à chaque passe.

7. Procédé selon l'une quelconque des revendications 3 à 6, **caractérisé en ce que** la vitesse d'avancement de la fraise est comprise entre 6,3 mm/min et 12,5 mm/min.

8. Procédé selon l'une quelconque des revendications 1 à 7, **caractérisé en ce que** ladite étape de modélisation comporte une étape de recueil de la position et de l'altitude d'un nombre prédéterminé de points sur ladite surface bombée initiale (18) et une modélisation de la surface initiale bombée à partir de fonctions SPLINE.

9. Procédé selon l'une quelconque des revendications 1 à 8, **caractérisé en ce que** ladite étape d'analyse de ladite surface bombée initiale (18) comporte une étape de mesure de l'altitude d'un nombre défini de points à l'aide d'un microscope confocal 3D ou d'un profilomètre optique 3D et ladite étape de modélisation comporte une étape de création d'un modèle de la surface à partir des altitudes mesurées.

## Claims

1. Process for thinning an integrated-circuit card (12) formed from a semiconductor material and exhibiting an initial curved surface (18), in which the initial curved surface (18) of the card is machined by a machining tool (48) in order to expose an underlying final surface, **characterised in that** said process comprises:
- a step of analysing said initial curved surface (18),
- a step of modelling said initial curved surface (18),
- a step of controlling the machining according to said modelling, said machining being conducted so that said final surface exhibits overall substantially the same profile as said initial curved surface (18), the final and initial surfaces extending overall generally in parallel and being separated at any point by a substantially identical interval,
- a step (50, 52) of defining a machining path (90) along which said machining tool is displaced, which machining path (90) extends in the three directions of space and includes, for at least one pass, a set of disjoint segments (92) passed through in succession, along which the machining tool (48) is displaced in a generally upward direction in relation to said curved initial surface (18), this step (50, 52) of defining the machining path comprising:
• delimitation of the surface to be machined into quarters defined by first (94) and second (96) median lines passing through the vertex (95) of the surface and perpendicular to one another,
• definition of a first pass in which the machining tool passes through disjoint machining segments (92, 93) from a low point of the surface to be machined to a high point of this surface, these machining segments (92, 93) being distributed on either side of the first median line (94) and on either side of the second median line (96), and in which the segments contained in each of the quarters are passed through by the machining tool in succession while progressively approaching the vertex, and
• definition of a second pass, following upon the first pass, along a configuration analogous to that of the first pass, this configuration being, however, offset by 90° in relation to that of the machining path of the first pass.

2. Process according to Claim 1, **characterised in that** said step of defining a machining path (53) includes a step (50) of defining the anticipated final surface and a step (52) of elaborating the machining path (53) on the basis of the anticipated final surface and on the basis of the dimensional characteristics of the machining tool (48).

3. Process according to any one of the preceding claims, **characterised in that** said machining tool is a generally spherical milling cutter (48) exhibiting axially a flat end surface (49).

4. Process according to Claim 3, **characterised in that** the diameter of the milling cutter is between 2 mm and 4 mm.

5. Process according to Claim 3 or 4, **characterised in that** the speed of rotation of the milling cutter is between 25,000 rpm and 75,000 rpm.

6. Process according to any one of Claims 3 to 5, **characterised in that** the mean thickness of removal of the semiconductor material is between 10 µm and 40 µm on each pass.

7. Process according to any one of Claims 3 to 6, **characterised in that** the speed of advance of the milling cutter is between 6.3 mm/min and 12.5 mm/min.

8. Process according to any one of Claims 1 to 7, **characterised in that** said modelling step includes a step of collecting the position and altitude of a predetermined number of points on said initial curved surface (18) and a modelling of the curved initial surface on the basis of spline functions.

9. Process according to any one of Claims 1 to 8, **characterised in that** said step of analysing said initial curved surface (18) includes a step of measuring the altitude of a defined number of points with the aid of a 3D confocal microscope or a 3D optical profilometer, and said modelling step includes a step of creating a model of the surface on the basis of the measured altitudes.

## Patentansprüche

1. Verfahren zum Dünnen eines aus einem Halbleitermaterial hergestellten Chips (12) mit integrierter Schaltung, der eine konvexe Ausgangsfläche (18) aufweist, bei dem die konvexe Ausgangsfläche (18) des Chips mit einem spanenden Werkzeug (48) bearbeitet wird, um eine darunter liegende Endfläche freizulegen, **dadurch gekennzeichnet, dass** das Verfahren folgende Schritte beinhaltet:
- einen Analyseschritt besagter konvexer Ausgangsfläche (18),
- einen Modellierungsschritt besagter konvexer Ausgangsfläche (18),
- einen Schritt zur Steuerung der Bearbeitung abhängig von besagter Modellierung, wobei besagte Bearbeitung dazu dient, dass besagte Endfläche insgesamt annähernd das gleiche Profil aufweist, wie besagte konvexe Ausgangsfläche (18), wobei die Endfläche und die Ausgangsfläche insgesamt im Allgemeinen parallel verlaufen und an jedem Punkt um einen annähernd identischen Abstand voneinander getrennt sind,
- einen Schritt (50, 52) zur Festlegung eines Bearbeitungswegs (90), nach dem besagtes Bearbeitungswerkzeug bewegt wird, wobei sich der Bearbeitungsweg (90) in den drei räumlichen Richtungen erstreckt und zumindest bei einem Arbeitsgang eine Reihe getrennter Segmente (92) enthält, die nacheinander durchlaufen werden, und entsprechend derer sich das Bearbeitungswerkzeug (48) in im Allgemeinen aufsteigender Richtung gegenüber besagter konvexer Ausgangsfläche (18) bewegt, wobei dieser Schritt (50, 52) zur Festlegung des Bearbeitungswegs folgendes umfasst:
• Aufteilung der zu bearbeitenden Oberfläche in Viertel, die durch die erste (94) und die zweite (96) Mittellinie festgelegt werden, die durch den Scheitelpunkt (95) der Fläche verlaufen und zueinander senkrecht stehen,
• Festlegung eines ersten Arbeitsgangs, bei dem das Bearbeitungswerkzeug getrennte Bearbeitungssegmente (92, 93) durchläuft, von einem unteren Punkt der zu bearbeitenden Oberfläche zu einem oberen Punkt dieser Fläche, wobei diese Bearbeitungssegmente (92, 93) auf beiden Seiten der ersten Mittellinie (94) und auf beiden Seiten der zweiten Mittellinie (96) verteilt sind, und wobei die in jedem Viertel liegenden Segmente vom Bearbeitungswerkzeug nacheinander unter allmählicher Annäherung an den Scheitelpunkt durchlaufen werden, und
• Festlegung eines zweiten Arbeitsgangs, der sich an den ersten Arbeitsgang anschließt, nach einer zu der des ersten Arbeitsgangs analogen Konfiguration, wobei diese Konfiguration jedoch um 90° gegenüber der des Bearbeitungswegs des ersten Arbeitsgangs versetzt ist.

2. Verfahren nach Anspruch 1, **dadurch gekennzeichnet, dass** besagter Festlegungsschritt eines Bearbeitungswegs (53) einen Schritt (50) zur Festlegung der erwarteten Endfläche und einen Schritt (52) zur Ausarbeitung des Bearbeitungswegs auf der Grundlage der erwarteten Endfläche und der Abmessungen des Bearbeitungswerkzeugs (48) beinhaltet.

3. Verfahren nach einem der vorangehenden Ansprüche, **dadurch gekennzeichnet, dass** es sich bei besagtem Bearbeitungswerkzeug im Allgemeinen um einen Kugelfräser (48) handelt, der axial eine Endabflachung (49) aufweist.

4. Verfahren nach Anspruch 3, **dadurch gekennzeichnet, dass** der Fräser einen Durchmesser zwischen 2 mm und 4 mm aufweist.

5. Verfahren nach Anspruch 3 oder 4, **dadurch gekennzeichnet, dass** der Fräser eine Drehzahl zwischen 25.000 min⁻¹ und 75.000 min⁻¹ aufweist.

6. Verfahren nach einem der Ansprüche 3 bis 5, **dadurch gekennzeichnet, dass** die mittlere Dicke des abgetragenen Halbleitermaterials zwischen 10 µm und 40 µm bei jedem Arbeitsgang liegt.

7. Verfahren nach einem der Ansprüche 3 bis 6, **dadurch gekennzeichnet, dass** die Vorschubgeschwindigkeit des Fräsers zwischen 6,3 mm/min und 12,5 mm/min liegt.

8. Verfahren nach einem der Ansprüche 1 bis 7, **dadurch gekennzeichnet, dass** besagter Modellierungsschritt einen Schritt zur Aufnahme der Position und Höhe einer vorbestimmten Anzahl von Punkten auf besagter konvexer Ausgangsfläche (18) und eine Modellierung der konvexen Ausgangsfläche auf der Grundlage von SPLINE-Funktionen beinhaltet.

9. Verfahren nach einem der Ansprüche 1 bis 8, **dadurch gekennzeichnet, dass** besagter Analyseschritt besagter konvexer Ausgangsfläche (18) einen Schritt zur Messung der Höhe einer bestimmten Anzahl von Punkten mit Hilfe eines 3D-Konfokalmikroskops und eines optischen 3D-Profilmessers beinhaltet, und besagter Modellierungsschritt einen Schritt zur Erzeugung eines Oberflächenmodells auf der Grundlage der gemessenen Höhen beinhaltet.
